# EUROPÄISCHE PATENTSCHRIFT

(11) **EP 0 396 923 B1**
(45) Veröffentlichungstag und Bekanntmachung des Hinweises auf die Patenterteilung: **10.02.1993**
(21) Anmeldenummer: 90106915.3
(22) Anmeldetag: 11.04.1990
(51) Int. Cl.: B65G 49/06, H01L 21/00

(54) **Hubtisch und Transportverfahren**
Elevating platform and conveyance method
Table élévatrice et méthode de transportation

(30) Priorität: 08.05.1989 DE 3915039
(43) Veröffentlichungstag der Anmeldung: 14.11.1990
(73) Patentinhaber: BALZERS AKTIENGESELLSCHAFT, 9496 Balzers (LI)
(72) Erfinder: Wagner, Rudolf, CH-9476 Fontnas (CH); Hirscher, Hans, Dr., CH-7310 Bad Ragaz (CH)
(74) Vertreter: Troesch, Jacques J., Dr. sc. nat.

(56) Entgegenhaltungen:
- EP-A- 0 244 950
- EP-A- 0 304 370
- FR-A- 2 559 953

## Beschreibung

Die Erfindung betrifft einen Hubtisch für den Transport eines auf- und abzubewegenden scheibenförmigen Werkstückes innerhalb einer Anlage für die Oberflächenbehandlung des Werkstückes, insbesondere innerhalb einer Vakuumanlage, mit zum Sichern des Werkstückes auf dem Hubtisch dienenden Halteorganen, sowie ein Verfahren zum Transportieren und Sichern eines scheibenförmigen Werkstückes in einer Oberflächenbehandlungskammer mittels eines Hubtisches für das Werkstück.

Ein Hubtisch dieser Art hat die Aufgabe, ein an der Oberfläche zu behandelndes Werkstück in Bearbeitungsposition der Behandlung zuzuführen. In Vakuumanlagen erfolgt dies innerhalb einer abgetrennten Kammer der Anlage. Beim Transport muss das Werkstück auf dem Hubtisch gesichert werden, damit es eine bestimmte Lage beibehält. In vielen Fällen ist eine ganz bestimmte Lage des Werkstückes auf dem Hubtisch für den anschliessend erfolgenden Oberflächenbehandlungsprozess erforderlich. Wenn es sich bei den Werkstücken beispielsweise um Halbleiterscheiben für die Herstellung integrierter Mikroelektronikbausteine handelt, so weist in der Regel jede Scheibe eine von der Kreisform abweichende Kontur auf, wobei ein Kreissegment weggeschnitten ist, was zur Kennzeichnung der Kristallorientierung dient.

Die Scheibenauflage des Hubtisches besitzt dann dieselbe von der Kreisform abweichende Kontur, und die Scheibe muss bezüglich dieser Auflage genau orientiert festgehalten und transportiert werden.

Es ist bekannt, zum Festhalten des Werkstückes gefederte Greiforgane bzw. Halteorgane zu verwenden, die den Werkstückrand umfassen und die sich in verschiedene Stellungen bringen lassen, um in einer Stellung das Werkstück festzuhalten.

So ist es aus der EP-A-0 250 064 bekannt, an einem Hubtisch für den Transport eines auf- und abzubewegenden scheibenförmigen Werkstückes innerhalb einer Vakuumanlage für die Oberflächenbehandlung des Werkstückes zur Werkstückoberfläche bzw. Hubtischauflagefläche geneigt angeordnete gefederte Haltekolben vorzusehen, welche an ihrem vorragenden Ende mit einem auskragenden Greifkopf versehen sind. Diese Haltekolben werden axial bewegt und klemmen in rückgeholter Position das Werkstück an der Hubtischauflage fest.

Für das Oberflächenätzen von Siliciumscheiben, wie mit verschiedenen Säuren, ist es weiter aus der EP-A-0 316 296 bekannt, auf der Hubtischauflage getrieben radial bewegliche Nocken vorzusehen, die das zu behandelnde Werkstück umfassen und festspannen.

Festhaltemittel dieser Art besitzen den Nachteil, dass sie der Oberflächenbehandlung im wesentlichen gleich wie das Werkstück ausgesetzt sind. Handelt es sich um eine Beschichtung, so bildet sich auf diesen Festhaltemitteln bzw. Halteorganen allmählich eine immer dicker werdende Schicht. Dadurch wird die Funktionsfähigkeit dieser Mittel in Frage gestellt, und wegen ihrer mechanischen Antriebsverbindung ist ein Ersetzen aufwendig.

Entsprechendes gilt auch, wenn der Oberflächenbehandlungsprozess beispielsweise ein Aetzprozess ist, wodurch die genannten Halteorgane allmählich abgetragen werden, was, insbesondere in Vakuumprozessen, durch Verunreinigung den Prozess beeinträchtigen kann.

Ausgehend von solchen Hubtischen liegt der vorliegenden Erfindung die Aufgabe zugrunde, einen Hubtisch mit Halteeinrichtungen zu schaffen, die geeignet sind, das Werkstück beim Transport zu sichern, Lagekorrekturen durchzuführen und welche schliesslich doch von den Auswirkung der Oberflächenbehandlung geschützt sind.

Zur Lösung dieser Aufgabe zeichnet sich der Hubtisch genannter Art nach dem kennzeichnenden Teil von Anspruch 1 aus, das Transportverfahren nach Anspruch 15.

Der Hubtisch besitzt den Vorteil, dass die innerhalb des Hubtisches auf kleinstem Raum angeordneten und mittels motorisch angetriebener Welle zwischen zwei Stellungen hin und her schwenkbaren Halteorgane in der einen Stellung das scheibenförmige Werkstück sichern und nach Erfüllen dieser Aufgabe, d.h. wenn der Hubtisch das Werkstück in die Behandlungskammer hochgefahren hat, in einer anderen Schwenkstellung den Einwirkungen der Oberflächenbehandlung entzogen sind.

Weitere Einzelheiten, insbesondere unter vakuumtechnischen Aspekten, zum Einsatz des genannten Hubtisches in Vakuumoberflächenbehandlungsanlagen ergeben sich aus der nachfolgenden Beschreibung und den Zeichnungen.

Es zeigen:
Fig. 1 einen Vertikalschnitt gemäss der Linie 1-1 in Fig. 2 durch den Hubtisch, dessen verschiedene Stellungen in bezug auf die durch den Hubtisch beschickte Behandlungskammer strichpunktiert dargestellt sind,
Fig. 2 eine Aufsicht auf die wesentlichen Teile des Hubtisches mit den Halteorganen.

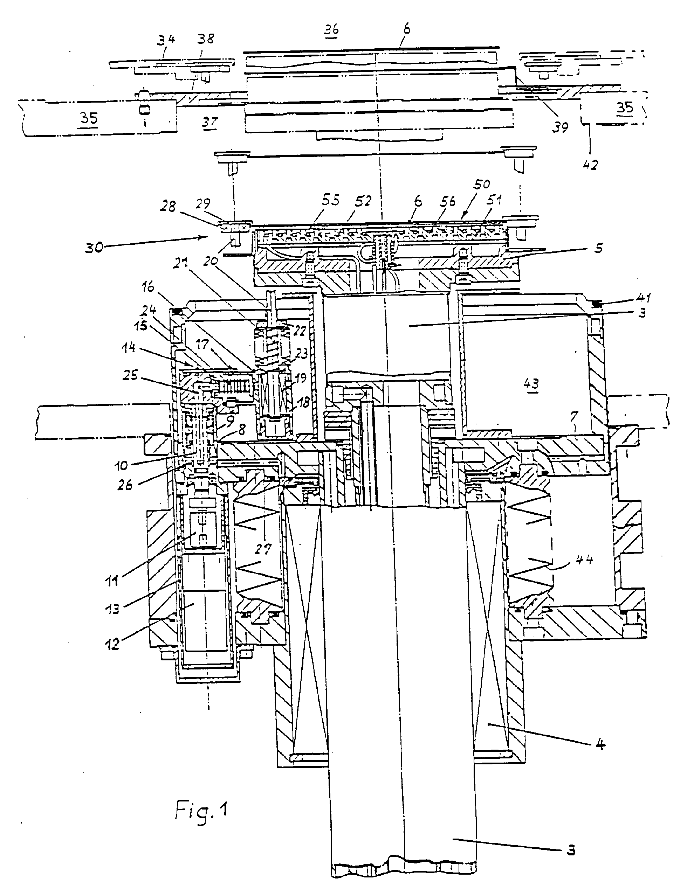

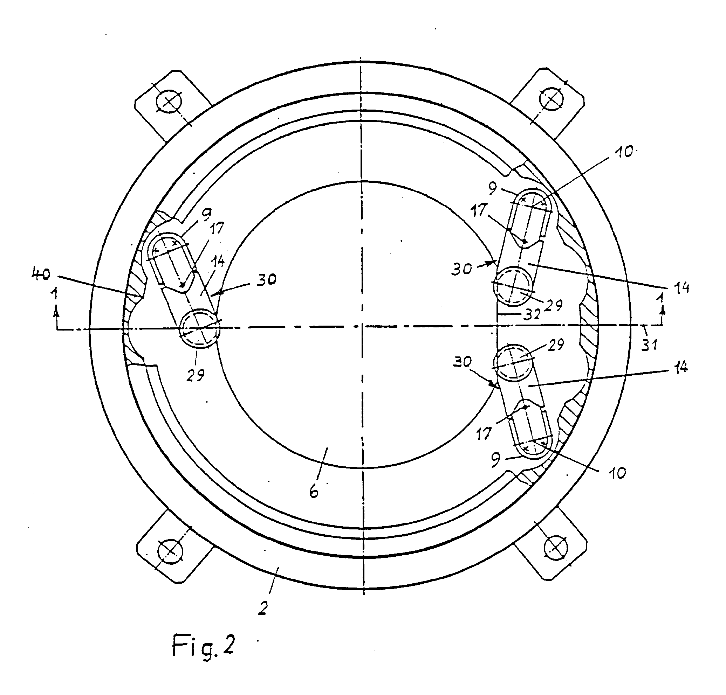

Der in Fig. 1 im Vertikalschnitt dargestellte Hubtisch 1 weist ein stufenförmig ausgebildetes Gehäuse 2 auf, in welchem eine Säule 3 mittels eines Lagers 4 auf- und abbewegbar gelagert ist. Als Lager dient eine Kugellagerbüchse, die eine nicht dargestellte Einrichtung nach dem Prinzip von zusammenwirkender Nut und Feder besitzt, um die Säule 3 im Gehäuse 2 drehungssicher zu lagern. Am oberen Ende trägt die Säule 3 eine koaxial zur Achse der Säule angeordnete Werkstückauflage 5, auf welcher ein scheibenförmiges Werkstück 6 aufliegt. Im Abstand unterhalb der Werkstückauflage 5 trägt die Säule 3 einen Ringflansch 7, in welchem gemäss Fig. 2 drei umfangsmässig verteilt angeordnete und den Ringflansch durchsetzende Ausnehmungen 8 ausgebildet sind, in welchen jeweils ein Lagerungskörper 9 angeordnet ist. In jedem Lagerungskörper 9 ist eine Welle 10 drehbar gelagert, die an ihrem unteren Ende über Kupplungselemente 11 mit einem Mikromotor 12 verbunden ist. Dieser Mikromotor ist unterhalb des Ringflansches 7 in einem am Ringflansch unterseitig befestigten Gehäuse 13 angeordnet. Am oberen Ende trägt die Welle 10 einen rechtwinklig zur Wellenachse sich erstreckenden zweigliedrigen Auslegerarm 14, der die beiden Glieder 15 und 16 umfasst, die durch eine zur Welle parallele Schwenkachse 17 miteinander verbunden sind, so dass das äussere Auslegerarmglied 16 gegenüber dem oben an der Welle 10 befestigten Auslegerarmglied 15 verschwenkbar ist. Der Auslegerarm 14 trägt am anderen Ende einen Lagerungskörper 18, in welchem mittels einer Kugellagerbuchse 19 eine zur Achse der Welle 10 parallele Stange 20 axial beweglich gelagert ist. Die Stange 20 ist gegen die Wirkung einer die Stange umschliessenden Druckfeder 21 axial verschieblich gehalten, welche die niedergedrückte Stange 20 wieder nach oben bewegt. Zu diesem Zweck ist die Druckfeder 21 mit ihrem unteren Ende am Lagerungskörper 18 abgestützt und mit dem oberen Ende an einem an der Stange befestigten Flansch 22 abgestützt. Am Flansch 22 ist ferner das eine Ende eines Metallfaltenbalges 23 befestigt, dessen anderes Ende am Lagerungskörper 18 befestigt ist. Dadurch ist innerhalb des Metallfaltenbalges 23 und des anschliessenden, am unteren Ende geschlossenen Lagerungskörpers 18 ein abgeschlossener Raum vorhanden, in den eine durch den Auslegerarm 14 innen sich hindurcherstreckende flexible Leitung 24 mündet, die flexibel ist, damit sich die beiden Glieder 15 und 16 des Auslegerarms 14 zueinander verschwenken lassen. Die Welle 10 ist hohl, und an diesen Hohlraum 25 ist die flexible Leitung 24 angeschlossen. Am motorseitigen Ende der Welle 10 ist der Hohlraum 25 über Querbohrungen 26 an einen durch den Ringflansch 7 in radialer Richtung sich hindurcherstreckenden Kanal 27 angeschlossen, welcher in nicht dargestellter Weise an eine Vakuumquelle angeschlossen ist, so dass alle vorstehend genannten, in Verbindung miteinander stehenden Räume evakuiert werden können. Eventuell durch Abrieb entstehende Partikel werden abgesaugt und gelangen nicht in den ebenfalls evakuierten Raum, in welchem der Hubtisch arbeitet. Ebenso können auch von den Lagerungen 9 und 19 keine Fremdkörper in diesen Raum gelangen.

In Fig. 1 ist der Vertikalschnitt durch den Auslegerarm und die anschliessenden Teile in der Zeichenebene liegend dargestellt, jedoch erstreckt sich in Wirklichkeit der Auslegerarm 14 unter einem Winkel zur vertikalen Schnittebene durch den Hubtisch 1, wie aus Fig. 2 hervorgeht, so dass die vorstehend beschriebene Stange 20 in Wirklichkeit seitlich neben der Werkstückauflage 5 endet und am Ende einen Drehring beispielsweise in Form eines Wälzlagers 28 und oberhalb des Wälzlagers eine Scheibe 29 trägt, die über den Rand des auf der Werkstückauflage 5 liegenden scheibenförmigen Werkstückes 6 greift, um das Werkstück festzuhalten. Der Drehring 28 ermöglicht die Abwälzbewegung, wenn die Stange 20 durch Verschwenken mittels ihres Drehfusses in Form der Welle 10 bei einer durch den Mikromotor 12 ausgelösten Schwenkbewegung gegen das Werkstück 6 angedrückt wird, um die Lage des Werkstückes auf der Werkstückauflage zu korrigieren. Die Stange als aktives Organ und alle vorstehend beschriebenen Teile für die Lagerung und Schwenkbewegung der Stange mittels Mikromotor wird nachfolgend als Halteorgan 30 bezeichnet, das noch weitere Funktionen hat. Wie aus Fig. 2 hervorgeht, sind insgesamt drei Halteorgane 30 vorhanden, von denen eines mit der Stange und der oberen Scheibe 29 auf der Symmetrielinie 31 durch die Werkstückauflage liegt und zwei weitere Halteorgane 30 beidseits dieser Symmetrielinie und dem einen Halteorgan diametral gegenüberliegen. Wie aus der Aufsicht gemäss Fig. 2 hervorgeht, haben die Scheibenauflage 5 und das daraufliegende scheibenförmige Werkstück 6 die gleiche Umrissform, nämlich kreisförmig mit einer an einer Seite längs einer Sehne verlaufenden geraden Kante 32. Gegen diese Kante werden zunächst die beiden Halteorgane 30, die zu beiden Seiten der Symmetrielinie 31 liegen, durch Verschwenken der Halteorgane um die Achse der Welle 10 mittels des Motors 12 angedrückt. Man bezeichnet die gerade Kante 32 bei dem scheibenförmigen Werkstück 6 auch als Flat.

Anschliessend wird das gegenüberliegende Halteorgan 30 verschwenkt und gegen das Werkstück angedrückt, und wenn dieses ursprünglich mit der geraden Kante 32 nicht genau parallel zu den beiden nebeneinander liegenden Halteorganen 30 auf der Werkstückauflage positioniert war, so wird es durch das gegenüberliegende Halteorgan zur Anlage gegen die beiden Halteorgane gebracht. Handelt es sich bei dem Werkstück beispielsweise um eine Halbleiterscheibe, so bezeichnet man diesen Vorgang als Korrektur der Scheibenorientierung, die für die nachfolgenden Behandlungsschritte wichtig ist. Die Stellung der Halteorgane in Eingriff ist auch in Fig. 1 in der unteren und in der mittleren Stellung des auf- und abbewegbaren Hubtisches dargestellt, während die durch eine Schwenkbewegung herbeigeführte Stellung ausser Eingriff in Fig. 1 ganz oben dargestellt ist. Das Halteorgan wird demnach nur um einen kleinen Winkel verschwenkt und gelangt in der Stellung, in der es ausser Eingriff ist, unter eine Abdeckung 34, gegen die die Stange 20 beim Hochfahren der Werkstückauflage 5 angedrückt wird, so dass die Stange gegen die Wirkung der Feder 21 einwärts gedrückt wird. In dieser hochgefahrenen Stellung ragt die Werkstückauflage 5 in eine oberhalb einer Vakuumkammerwand 35 befindliche Prozesskammer 36 hinein, wobei die Halteorgane 30 dann unter der Abdeckung 34 geschützt liegen, so dass die in der Prozesskammer 36 stattfindende Behandlung der Werkstückoberfläche, beispielsweise eine Beschichtung mit Aluminium oder ein Aetzprozess auf die geschützt liegenden Halteorgane sich nicht auswirken kann. Es kann also keine Beschichtung auf den Halteorganen aufwachsen.

Zwischen der Werkstückauflage 5 und der Vakuumkammerwand 35 ist ein offener Ringspalt 37 vorhanden, der durch einen losen Ring 38 abgedeckt ist, der am Innenumfang mit mehreren Haken 39 versehen ist, mit denen der Ring 38 am Rand des Werkstückes 6 hängend angeordnet ist, wenn die Werkstückauflage 5 sich in der hochgefahrenen Stellung befindet. Der Ring dient gleichzeitig als Gewichtsbelastung und fixiert das Werkstück.

Der an der Säule 3 fest angeordnete Ringflansch 7 ist am Aussenrand mit einem zur Säule koaxialen Zylinderkörper 40 fest verbunden, dessen gegenüber der Werkstückauflage 5 tiefer liegende obere Stirnringfläche 41 als Ventilschliessorgan ausgebildet ist, das gegen eine als Ventilsitz ausgebildete Ringfläche 42 an der Vakuumkammerwand 35 zur Anlage kommt, wenn der Hubtisch in die Bearbeitungsstation hochgefahren ist, so dass in dieser Stellung die Werkstückauflage 5 in die Bearbeitungs- oder Prozesskammer 36 hineinragt und gleichzeitig diese Kammer gegen den Nachbarraum abgedichtet ist. Zwischen der Säule 3 und dem an dem Ringflansch 7 befestigten Zylinderkörper 40 ist ein Ringraum 43 vorhanden, in dem die wesentlichen Teile der Halteorgane 30 untergebracht sind, von denen sich nur die Stangen 20 nach oben aus dem Ringraum 43 heraus erstrecken.

Ein Metallfaltenbalg 44, dessen oberes Ende unterseitig am Ringflansch 7 und dessen unteres Ende am Boden des Gehäuses 2 befestigt ist, ermöglicht die Auf- und Abbewegung der Werkstückauflage 5 in einem Raum, der ebenfalls evakuiert wird und der mit dem Raum unterhalb des Ringflansches 7 in Verbindung steht und mittels des Metallfaltenbalges 44 daher von dem übrigen nach unten sich anschliessenden Raum abzutrennen ist.

Damit das Werkstück 6 sich während der Oberflächenbehandlung nicht auf der Werkstückauflage 5 verschiebt, wird das Werkstück 6 durch das Gewicht eines losen Ringes 38 belastet, der mit Hilfe der am Ring befestigten Haken 39 am Rand des Werkstückes 6 hängt.

Wie in Fig. 1 weiter angedeutet, kann die Werkstückauflage 5 eine elektrische Heizeinrichtung 50 aufweisen, mit einem Heizdraht 56, der in Nuten 52 einer Platte 51 angeordnet ist. Die Nuten 52 sind durch eine das Werkstück 6 tragende Abdeckplatte 55 abgedeckt und können zur Zuführung eines Gases als Wärmeübertragungsmedium dienen, das durch zahlreiche Bohrungen in der Abdeckplatte austreten kann, um an der Werkstückrückseite ein Gaspolster zu bilden.

## Patentansprüche

1. Hubtisch für den Transport eines auf- und abzubewegenden, scheibenförmigen Werkstückes innerhalb einer Anlage für die Oberflächenbehandlung des Werkstückes, insbesondere innerhalb einer Vakuumanlage, mit zum Sichern des Werkstückes auf dem Hubtisch dienenden Halteorganen, dadurch gekennzeichnet, dass eine in einem Gehäuse (2) auf- und abbewegbar gelagerte Säule (3) am oberen Ende eine die Säule überkragende Werkstückauflage (5) und, im Abstand unterhalb dieser, einen die Werkstückauflage in Aufsicht überkragenden, fest an der Säule angeordneten Ringflansch (7) trägt, an dessen äusserem Bereich Lagerungskörper (9) angeordnet sind, in denen jeweils eine parallel zur Achse der Säule (3) sich erstreckende Welle (10), mittels eines Motors (12) getrieben, drehbar gelagert ist, und die am oberen Ende einen rechtwinklig zur Wellenachse sich erstreckenden, zweigliedrigen Auslegearm (14, 15, 16) mit einem eine zur Wellenachse parallele Schwenkachse (17) aufweisenden Schwenkgelenk zwischen den Auslegearmgliedern (15, 16) trägt, welcher Auslegearm (14) am anderen Ende einen Lagerungskörper (18) trägt, in welchem eine zur Wellenachse parallele Stange (20) axial beweglich gelagert und gegen die Wirkung einer Feder axial verschieblich gehalten ist, welche Stange (20) sich nach oben und seitlich der Werkstückauflage (5) bis zu deren Oberkante erstreckt und am Ende ein Halteorgan (30) trägt.

2. Hubtisch nach Anspruch 1, dadurch gekennzeichnet, dass das Halteorgan (30) einen Drehring (28) zum Andrücken gegen den Werkstückrand umfasst.

3. Hubtisch nach einem der Ansprüche 1 oder 2, dadurch gekennzeichnet, dass das Halteorgan einen Rand (29) aufweist zum Uebergreifen über den Werkstückrand.

4. Hubtisch nach einem der Ansprüche 1 bis 3, dadurch gekennzeichnet, dass am Ringflansch (7) drei Lagerungskörper (9) derart angeordnet sind, dass das eine Halteorgan (30) auf die Symmetrielinie (31) durch die Werkstückauflage (5) schwenkbar ist und zwei weitere beidseits der Symmetrielinie (31) und dem einen diametral gegenüberliegend.

5. Hubtisch nach einem der Ansprüche 1 bis 4, dadurch gekennzeichnet, dass der Ringflansch (7) am Aussenrand mit einem zur Säule koaxialen Zylinderkörper (40) fest verbunden ist, dessen obere Stirnfläche (41) als Ventilschliessorgan zwecks eine Abdichtung bewirkender Anlage gegen eine Vakuumkammerwand (35) bei hochgefahrenem Hubtisch (1) ausgebildet ist, wobei Motoren für die Wellen (10) unterhalb des Ringflansches (7) angeordnet und von einem an diesen unterseitig befestigten Schutzgehäuse (13) umschlossen sind.

6. Hubtisch nach einem der Ansprüche 1 bis 5, dadurch gekennzeichnet, dass ein an dem Lagerungskörper (18) für die Stange (20) mit einem Ende befestigter Metallbalg (23) mit seinem anderen Ende an der Stange (20) befestigt ist.

7. Hubtisch nach Anspruch 6, dadurch gekennzeichnet, dass eine Druckfeder (21) für die Stange (20) innerhalb des Balges (23) angeordnet ist.

8. Hubtisch nach einem der Ansprüche 1 bis 7, dadurch gekennzeichnet, dass der Lagerungskörper (18) für die Stange (20) eine unten geschlossene Büchse ist.

9. Hubtisch nach Anspruch 7, dadurch gekennzeichnet, dass im Lagerungskörper (18) und innerhalb des Metallfaltenbalges (23) eine Führung für die Stange (20), wie eine Kugellagerbüchse (19), vorgesehen ist.

10. Hubtisch nach einem der Ansprüche 1 bis 9, dadurch gekennzeichnet, dass der Innenraum des Lagerungskörpers (18) mittels eines Metallfaltenbalges und der Stange (20) geschlossen ist und dass eine flexible Leitung (24) an den Innenraum des Lagerungskörpers (18) angeschlossen ist, die an eine Vakuumquelle angeschlossen ist, um den Innenraum des Lagerungskörpers (18) zu evakuieren.

11. Hubtisch nach Anspruch 10, dadurch gekennzeichnet, dass die Welle (10) als Hohlwelle ausgebildet ist, sich die flexible Leitung (24) zwischen Innenraum des Lagerungskörpers (18) und Hohlraum der Welle (10) erstreckt, und dass bevorzugterweise der Hohlraum (25) der Welle (10) über Querbohrungen (26) an einen innerhalb des Ringflansches (7) sich radial erstreckenden Kanal (27) angeschlossen ist.

12. Hubtisch nach einem der Ansprüche 1 bis 11, dadurch gekennzeichnet, dass zwischen dem Ringflansch (7) und dem Gehäuse (2), bevorzugterweise unterhalb des Ringflansches (7), ein Metallfaltenbalg (44) vorgesehen ist.

13. Hubtisch nach einem der Ansprüche 1 bis 12, dadurch gekennzeichnet, dass eine gehäusefeste Abdekkung (34) vorgesehen ist, hinter die die Halteorgane bei Hochfahren des Hubtisches gegen die Wirkung der Feder (21) gespannt einer Oberflächenbehandlung entzogen werden.

14. Hubtisch nach einem der Ansprüche 1 bis 13, dadurch gekennzeichnet, dass ein loser Ring (38), vorzugsweise mit Haken (39) koaxial zur Achse der Säule (3) an gehäusefesten Partien aufliegend, vorgesehen ist und, bei Hochfahren des Hubtisches, über die Haken (39), das Werkstück halternd belastet.

15. Verfahren zum Transportieren eines scheibenförmigen Werkstückes auf einem Hubtisch in die Behandlungsposition einer Oberflächenbehandlungsanlage, unter gleichzeitiger Lagesicherung des Werkstückes auf dem Hubtisch mittels an dem Werkstück angreifenden Halteorganen, wobei zuerst die Halteorgane gegen das auf dem Hubtisch liegende Werkstück zur Anlage gebracht und das Werkstück dadurch auf dem Hubtisch positioniert wird,
anschließend der Hubtisch unter Beibehaltung des Eingriffs der Halteorgane, in Richtung auf die Behandlungsposition bewegt,
und dann die Halteorgane von dem Hubtisch weg in eine Ausrückposition, in der sie durch eine Abdeckung gegen die Oberflächenbehandlung abgedeckt sind, bewegt werden.

16. Verfahren nach Anspruch 15, dadurch **gekennzeichnet,** daß auf das Werkstück in der Behandlungsposition eine Haltekraft durch einen das Werkstück umgebenden, es an peripheren Stellen übergreifenden, lose aufliegenden Ring ausgeübt wird.

## Claims

1. A lift table for the transportation of a discoid workpiece which is to be moved up and down, within an installation for the surface treatment of the workpiece, in particular within a vacuum installation, with holding members serving to secure the workpiece on the lift table, characterised in that a pillar (3) which is mounted movably up and down in a housing (2) carries at the upper end a workpiece support (5) which projects beyond the pillar and, at a spacing beneath the workpiece support, an annular flange (7) which is fixedly arranged on the pillar and which in plan view projects beyond the workpiece support and at the outer region of which are disposed mounting bodies (9), in each of which is rotatably mounted a respective shaft (10) extending parallel to the axis of the pillar (3), driven by a motor (12), and which at the upper end carries a two- member cantilever arm (14, 15, 16) extending at a right angle to the axis of the shaft, with a pivot connection between the cantilever arm members (15, 16), the pivot connection having a pivot axis (17) which is parallel to the axis of the shaft, which cantilever arm (14) carries at the other end a mounting body (18) in which a rod (20) which is parallel to the axis of the shaft is axially movably mounted and is held axially displaceably against the action of a spring, which rod (20) extends upwardly and laterally of the workpiece support (5) to the top edge thereof and at the end carries a holding member (30).

2. A lift table according to claim 1 characterised in that the holding member (30) includes a rotary ring (28) for pressing against the workpiece edge.

3. A lift table according to one of claims 1 and 2 characterised in that the holding member has an edge (29) for engaging over the workpiece edge.

4. A lift table according to one of claims 1 to 3 characterised in that three mounting bodies (9) are arranged on the annular flange (7) in such a way that the one holding member (30) is pivotable on to the line of symmetry (31) through the workpiece support (5) and two further holding members on both sides of the line of symmetry (31) and diametrally opposite to the one holding member.

5. A lift table according to one of claims 1 to 4 characterised in that the annular flange (7) is fixedly connected at the outer edge to a cylindrical body (40) which is coaxial with respect to the pillar and the upper end face (41) of which is in the form of a valve closing member for the purposes of contact producing a sealing action against a vacuum chamber wall (35) when the lift table (1) is raised, wherein motors for the shafts (10) are arranged beneath the annular flange (7) and are enclosed by a protective housing (13) which is secured to the annular flange at the underside thereof.

6. A lift table according to one of claims 1 to 5 characterised in that a metal bellows (23) which is fixed by one end to the mounting body (18) for the rod (20) is fixed by its other end to the rod (20).

7. A lift table according to claim 6 characterised in that a compression spring (21) for the rod (20) is disposed within the bellows (23).

8. A lift table according to one of claims 1 to 7 characterised in that the mounting body (18) for the rod (20) is a downwardly closed sleeve.

9. A lift table according to claim 7 characterised in that a guide for the rod (20) such as a ball bearing sleeve (19) is provided in the mounting body (18) and within the metal bellows (23).

10. A lift table according to one of claims 1 to 9 characterised in that the interior of the mounting body (20) is closed by means of a metal bellows and the rod (20) and that a flexible line (24) is connected to the interior of the mounting body (18), which line is connected to a vacuum source for evacuating the interior of the mounting body (18).

11. A lift table according to claim 10 characterised in that the shaft (10) is in the form of a hollow shaft, the flexible line (24) extends between the interior of the mounting body (18) and the cavity in the shaft (10), and that preferably the cavity (25) in the shaft (10) is connected by way of transverse bores (26) to a duct (27) extending radially within the annular flange (7).

12. A lift table according to one of claims 1 to 11 characterised in that a metal bellows (44) is provided between the annular flange (7) and the housing (2), preferably beneath the annular flange (7).

13. A lift table according to one of claims 1 to 12 characterised in that there is provided a cover (34) which is fixed with respect to the housing and behind which the holding members are withdrawn from a surface treatment operation, when the lift table is raised, stressed against the force of the spring (21).

14. A lift table according to one of claims 1 to 13 characterised in that there is provided a loose ring (38), preferably with hooks (39), lying coaxially with respect to the axis of the pillar (3) on parts which are fixed with respect to the housing, which ring, when the lift table is raised, loads the workpiece to hold same by way of the hooks (39).

15. A method of transporting a discoid workpiece on a lift table into the treatment position of a surface treatment installation, with at the same time the workpiece being secured in position on the lift table by means of holding members engaging the workpiece, wherein firstly the holding members are brought to bear against the workpiece which is lying on the lift table and the workpiece is thereby positioned on the lift table, then the lift table is moved towards the treatment position, with the engagement of the holding members being maintained, and then the holding members are moved away from the lift table into a disengagement position in which they are covered relative to the surface treatment operation by a cover.

16. A method according to claim 15 characterised in that a holding force is applied to the workpiece in the treatment position by a loosely supported ring which surrounds the workpiece and which engages over it at peripheral locations.

## Revendications

1. Table élévatrice destinée au transport d'une pièce en forme de disque, à déplacer vers le haut et vers le bas dans une installation de traitement de surface de la pièce, plus particulièrement dans une installation sous vide, comportant des éléments de retenue servant à tenir la pièce sur la table élévatrice, caractérisée en ce que, dans un carter (2), il est logé une colonne (3) se déplaçant vers le haut et vers le bas, laquelle est équipée à son extrémité supérieure d'un support de pièce (5) surmontant la colonne, et en ce qu'en-dessous et à un certain écartement de ce dernier, une bride annulaire (7) débordant le support de pièce en vue de dessus, est fixée sur la colonne, dont la zone extérieure comporte des corps de logement (9), un arbre (10) entraîné par un moteur (12) et s'étendant parallèlement à l'axe de la colonne (3) étant logé en rotation dans chacun de ces logements, et dont l'extrémité supérieure est équipée d'une potence à deux éléments (14, 15, 16) s'étendant à angle droit de l'axe de l'arbre et comportant un élément d'articulation avec un axe de rotation (17) parallèle à l'axe de l'arbre entre les éléments de potence (15, 16), l'autre extrémité de la potence (14) étant munie d'un corps de logement (18), dans lequel une tige (20) mobile axialement est logée parallèlement à l'axe de l'arbre et déplaçable axialement en s'opposant à l'effort d'un ressort, la tige (20) dont l'extrémité est équipée d'un élément de retenue (30) s'étendant vers le haut et sur le côté du support de pièce (5) jusqu'au bord supérieur de ce dernier.

2. Table élévatrice selon la revendication 1, caractérisée en ce que l'élément de retenue (30) comprend une bague rotative (28) pour prendre appui contre le bord de la pièce.

3. Table élévatrice selon l'une quelconque des revendications 1 ou 2, caractérisée en ce que l'élément de retenue comporte un bord (29) pour saisir le bord de la pièce par le dessus.

4. Table élévatrice selon l'une quelconque des revendications 1 à 3, caractérisée en ce que trois corps de logement (9) sont prévus sur la bride annulaire (7) de telle manière qu'un des éléments de retenue (30) peut être pivoté sur l'axe de symétrie (31) passant à travers le support de pièce (5) et les deux autres des deux côtés de l'axe de symétrie (31) et diamétralement opposés à celui cité en premier.

5. Table élévatrice selon l'une quelconque des revendications 1 à 4, caractérisée en ce que le bord extérieur de la bride annulaire (7) est relié en fixe à un corps de cylindre (40) coaxial à la colonne, dont la surface annulaire frontale supérieure (41) est réalisée sous forme d'un élément d'obturation de vanne, afin d'exercer un appui étanche contre une cloison (35) de chambre sous vide lorsque la table élévatrice (1) est en position haute, les moteurs des arbres (10) étant installés en-dessous de la bride annulaire (7) et entourés par un carter de protection (13) fixé en partie inférieure de cette dernière.

6. Table élévatrice selon l'une quelconque des revendications 1 à 5, caractérisée en ce qu'une extrémité d'un soufflet métallique (23) est fixée sur le corps de logement (18), de la tige (20), et que l'autre extrémité est fixée sur la tige (20).

7. Table élévatrice selon la revendication 6, caractérisée en ce qu'un ressort de compression (21) pour la tige (20) est disposé dans le soufflet (23).

8. Table élévatrice selon l'une quelconque des revendications 1 à 7, caractérisée en ce que le corps de logement (18) de la tige (20) est un coussinet dont la partie inférieure est fermée.

9. Table élévatrice selon la revendication 7, caractérisée en ce qu'il est prévu un guidage pour la tige (20) dans le corps de logement (18) et dans le soufflet métallique (23), ainsi qu'un coussinet à roulement à billes (19).

10. Table élévatrice selon l'une quelconque des revendications 1 à 9, caractérisée en ce que l'espace intérieur du corps de logement (18) est fermé au moyen d'un soufflet métallique et de la tige (20), et en ce qu'une liaison flexible (24) est raccordée à l'espace intérieur du corps de logement (18), laquelle est raccordée à une source de vide pour faire le vide dans l'espace intérieur du corps de logement (18).

11. Table élévatrice selon la revendication 10, caractérisée en ce que l'arbre (10) est réalisé sous forme d'un arbre creux, en ce que la liaison flexible (24) s'étend entre l'espace intérieur du corps de logement (18) et l'espace creux de l'arbre (10), et en ce que l'espace creux (25) de l'arbre (10) est de préférence relié par l'intermédiaire de perçages (26) à un canal (27) s'étendant radialement à l'intérieur de la bride annulaire (7).

12. Table élévatrice selon l'une quelconque des revendications 1 à 11, caractérisée en ce qu'il est prévu un soufflet métallique (44) entre la bride annulaire (7) et le carter (2), de préférence au-dessous de la bride annulaire (7).

13. Table élévatrice selon l'une quelconque des revendications 1 à 12, caractérisée en ce qu'il est prévu un recouvrement (34) de capotage fixe, sous lequel les éléments de retenue comprimés par l'effort du ressort (21) sont soustraits à un traitement de surface lorsque la table élévatrice est en position haute.

14. Table élévatrice selon l'une quelconque des revendications 1 à 13, caractérisée en ce qu'il est prévu un anneau libre (38) prenant appui sur des parties fixes du carter, de préférence avec des crochets (39) disposés coaxialement à l'axe de la colonne (3), l'anneau tenant par les crochets (39) la pièce avec son poids lorsque la table élévatrice est en position haute.

15. Procédé pour le transport sur une table élévatrice d'une pièce en forme de disque dans la position dans laquelle elle sera traitée dans une installation de traitement de surface, en assurant simultanément la position de la pièce sur la table élévatrice par des éléments de retenue contactant la pièce, les éléments de retenue étant d'abord mis en appui contre la pièce se trouvant sur la table élévatrice ce qui positionne la pièce sur la table élévatrice, la table élévatrice étant ensuite déplacée vers la position de traitement tout en maintenant les éléments de retenue en appui sur la pièce, puis les éléments de retenue sont retirés de la table élévatrice et mis dans une position de retrait, dans laquelle ils sont protégés par un recouvrement contre le traitement de surface.

16. Procédé selon la revendication 15, caractérisé en ce qu'une force de maintien est exercée sur la pièce en position de traitement par un anneau librement posé entourant la pièce, et débordant à certains endroits de sa périphérie.
